# EUROPEAN PATENT APPLICATION

(11) **EP 4 815 669 A2**
(43) Date of publication of application: **30.09.2026**
(21) Application number: 26160281.7
(22) Date of filing: 24.02.2026
(51) Int. Cl.: H10D 62/10, H10D 30/01, H10D 30/43, H10D 30/00, H10D 64/23, H10D 64/27

(54) **NANORIBBON-BASED TRANSISTOR WITH BACKSIDE GATE CONTACT**

(30) Priority: 25.03.2025 US 202519089338
(71) Applicant: INTEL Corporation, Santa Clara, CA 95054 (US)
(72) Inventor: YEUNG, Chun Wing, Portland, 97229 (US); CHU, Tao, Portland, 97229 (US); XU, Guowei, Portland, 97229 (US); HU, Lin, San Jose, 95124 (US); ZHANG, Feng, Portland, 97229 (US); HUNG, Ting-Hsiang, Santa Clara, 95051 (US); LIN, Chia-Ching, Portland, 97229 (US); ZHANG, Yang, Rio Rancho, 87124 (US); ZHANG, Kan, Hillsboro, 97123 (US); JANG, Minwoo, Portland, 97229 (US); LUO, Yanbin, Portland, 97229 (US); PACKAN, Paul, Hillsboro, 97124 (US); LIN, Chung-Hsun, Portland, 97229 (US); GHANI, Tahir, Portland, 97229 (US)
(74) Representative: HGF

(57) **Abstract**

Integrated circuit (IC) structures including a nanoribbon-based transistor with a backside gate contact in addition to a frontside gate contact can reduce the effective gate resistance. In one example, an IC structure includes one or more nanoribbons of a semiconductor material, a gate electrode material at least partially around the one or more nanoribbons, a first gate contact structure (e.g., a frontside gate contact) over the one or more nanoribbons and coupled with the gate electrode material, and a second gate contact structure (e.g., a backside gate contact) below the one or more nanoribbons and coupled with the gate electrode material. A conductive via over the one or more nanoribbons may be coupled with the frontside gate contact and a conductive via below the one or more nanoribbons may be coupled with the backside gate contact.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component (e.g., the conductive interconnects for signaling, power delivery, and ground) is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon field-effect transistor (FET), according to one embodiment of the present disclosure.
FIGS. 2A-2C are top-down views of an IC device including a nanoribbon-based transistor with a backside gate contact, according to one embodiment of the present disclosure.
FIGS. 3A-3C are cross-sectional side views along different cross-sections of the IC device of FIG. 2A, according to some embodiments of the present disclosure.
FIG. 4 is a flow diagram of an example method for fabricating an IC structure including a nanoribbon-based transistor with a backside gate contact, in accordance with some embodiments.
FIGS. 5A-5D provide cross-sectional side views at various stages in the fabrication of an example IC structure according to the method of FIG. 4, in accordance with some embodiments.
FIG. 6 provides a cross-sectional view of an example IC structure including a nanoribbon-based transistor with a backside gate contact, according to embodiments of the present disclosure.
FIG. 7 is a top view of a wafer and dies that may include any of the IC devices disclosed herein, in accordance with any of the embodiments disclosed herein.
FIG. 8 is a side, cross-sectional view of an IC package that may include any of the IC devices disclosed herein, in accordance with various embodiments.
FIG. 9 is a side, cross-sectional view of an IC device assembly that may include any of the IC devices disclosed herein, in accordance with any of the embodiments disclosed herein.
FIG. 10 is a block diagram of an example electrical device that may include any of the IC devices disclosed herein, in accordance with any of the embodiments disclosed herein.

### Detailed Description

Disclosed herein are IC structures and devices including a nanoribbon-based transistor with a backside gate contact. The systems, methods, and devices of this disclosure each have several innovative aspects, no single one of which is solely responsible for all desirable attributes disclosed herein. Details of one or more implementations of the subject matter described in this specification are set forth in the description below and the accompanying drawings.

As IC structures become more compact with smaller feature sizes and higher device density, new challenges arise in the fabrication processes of such devices. For example, as feature sizes shrink, the contact area between features may decrease, which can result in increased resistance. For example, a small contact area between a metal gate structure and a gate contact may result in high resistance, which can negatively impact device performance. In particular, in some examples, the maximum frequency that can be supported by a circuit is inversely proportional to gate resistance. Therefore, reducing gate resistance can enable higher maximum frequencies, which can be especially impactful for radio frequency (RF) circuits or other analog circuits that operate at high frequencies.

According to examples, a gate connection from both the front side and the back side can reduce the effective gate resistance, in some cases by about half. In one example, an IC structure includes one or more nanoribbons of a semiconductor material, a gate electrode material at least partially around the one or more nanoribbons, a first gate contact structure (e.g., a frontside gate contact) over the one or more nanoribbons and coupled with the gate electrode material, and a second gate contact structure (e.g., a backside gate contact) below the one or more nanoribbons and coupled with the gate electrode material. A conductive via over the one or more nanoribbons may be coupled with the frontside gate contact and a conductive via below the one or more nanoribbons may be coupled with the backside gate contact.

IC structures as described herein, in particular IC structures including a nanoribbon-based transistor with a backside gate contact, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures including a nanoribbon-based transistor with a backside gate contact as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

IC structures including a nanoribbon-based transistor with a backside gate contact described herein may also include transistors of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

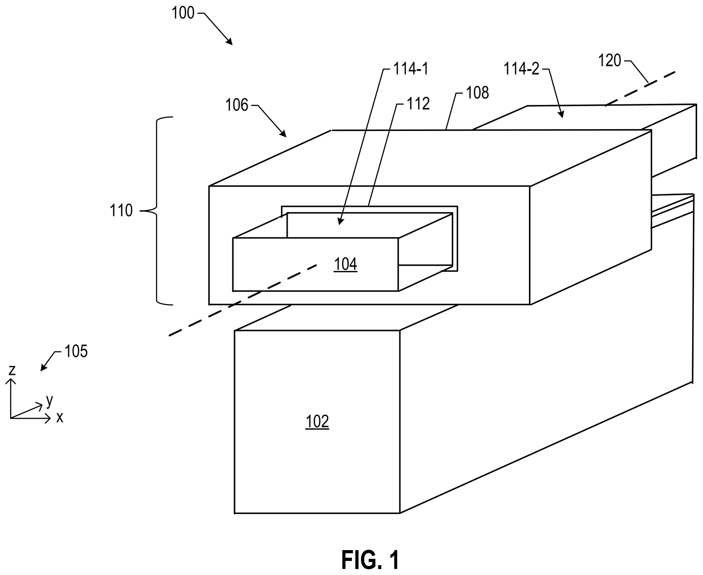

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 1, FIGS. 2A-2C, and FIGS. 3A-3C), although IC structures including a nanoribbon-based transistor with a backside gate contact as described herein may include other devices instead of or in addition to nanoribbon transistors, and are not limited to such transistors.

As used herein, the term "nanoribbon" refers to an elongated structure of a semiconductor material having a longitudinal axis parallel to a support structure (e.g., a substrate, a die, a chip, or a wafer) over which such a structure is built. Typically, a length of a such a structure (i.e., a dimension measured along the longitudinal axis, shown in the present drawings to be along the y-axis of an example x-y-z coordinate system 105 shown in FIG. 1) is greater than each of a width (i.e., a dimension measured along the x-axis of the coordinate system 105) and a thickness/height (i.e., a dimension measured along the z-axis of the coordinate system 105). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain regions of a transistor provided on either side of the channel material.

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

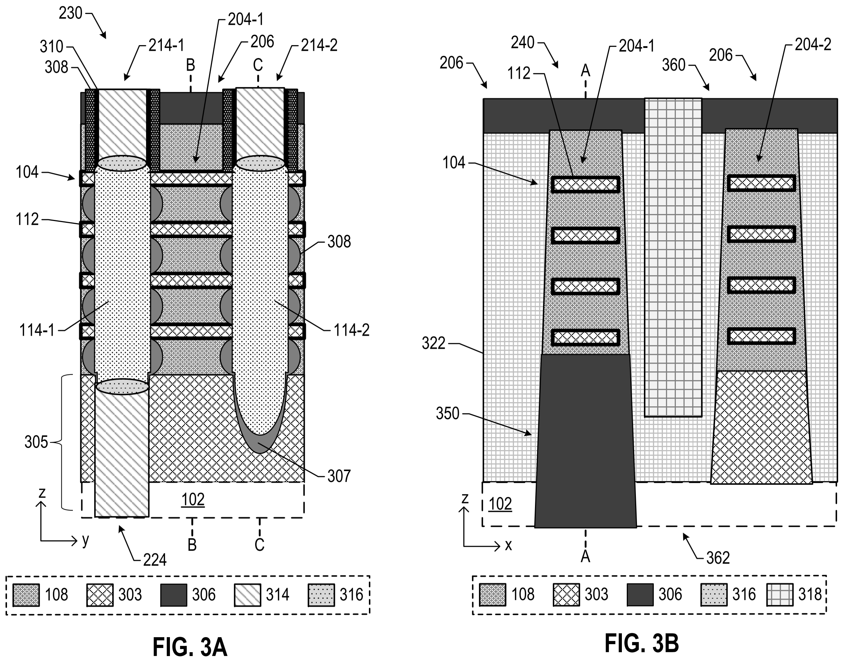

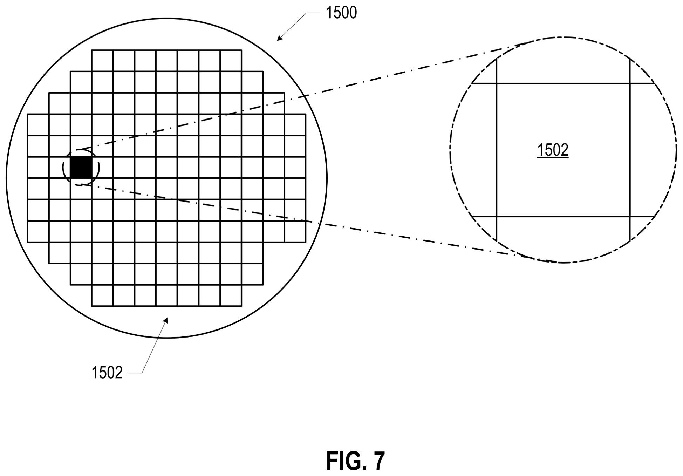

Implementations of the present disclosure may be formed or carried out on any suitable support 102, such as a substrate, a die, a wafer, or a chip. The support 102 may, e.g., be the wafer 1500 of FIG. 7, discussed below, and may be, or be included in, a die, e.g., the singulated die 1502 of FIG. 7, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure including a nanoribbon-based transistor with a backside gate contact as described herein may be built falls within the scope of the present disclosure. Although only one nanoribbon 104 is shown in FIG. 1, the IC structure 100 may include a stack of such nanoribbons where a plurality of nanoribbons 104 are stacked above one another. For example, FIGS. 3A-3C show IC structures that may be examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system 105 shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system 105) may be at least about 3 times larger than a height of the nanoribbon 104 (i.e., a dimension measured in a plane perpendicular to the support 102, e.g., along the z-axis of the coordinate system 105), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and a PMOS transistor include gate materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided above.

Turning to the S/D regions 114-1, 114-2 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114-1, 114-2.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1 and 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

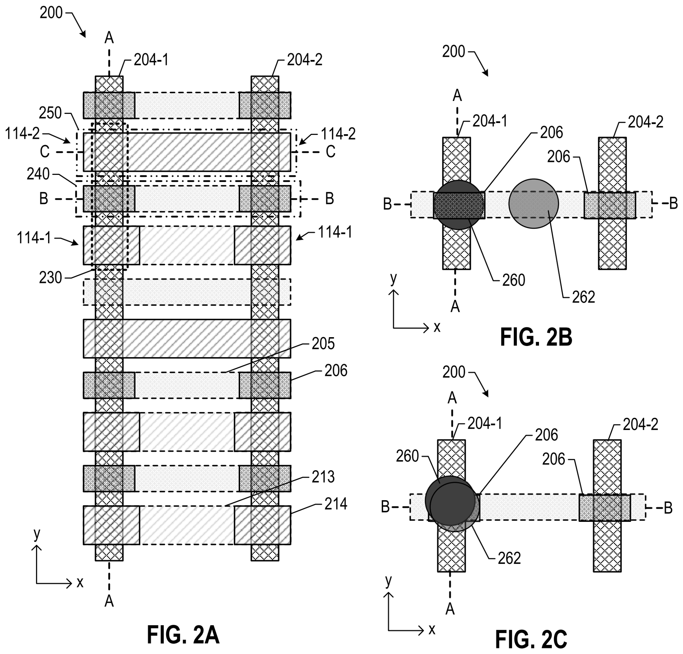

FIGS. 2A-2C are top-down views of an IC structure 200 that may include including a nanoribbon-based transistor with a backside gate contact as described herein. Some of the materials are not shown in the top-down view in order to not obscure the drawing.

As shown in FIG. 2A, the IC structure 200 may include two nanoribbon stacks 204-1 and 204-2 if the transistors to be implemented in the IC structure 200 are nanoribbon transistors such as the one illustrated in FIG. 1. Alternatively, what is now shown as nanoribbon stacks 204-1 and 204-2 could be fins if the transistors to be implemented in the IC structure 200 are FinFETs. The nanoribbon stacks 204-1, 204-2 may include stacks of one or more nanoribbons 104 as described above and may be provided over a support such as the support 102 (not specifically shown in FIG. 2A). The nanoribbon stacks 204-1, 204-2 may extend substantially parallel to one another, e.g., along the y-axis of the coordinate system 105, consistent with the illustration of FIG. 1. Metal gate lines 205 (shown in FIG. 2A to be within dashed contours) and S/D contact lines 213 may extend substantially perpendicular to the nanoribbon stacks 204-1, 204-2 and substantially parallel to one another, e.g., along the x-axis of the coordinate system 105. FIG. 2A illustrates that the metal gate lines 205 and the S/D contact lines 213 may be provided in an alternating manner. Metal gate lines 205 may be cut and removed (e.g., where isolation regions or deep trench vias are placed). In other examples, metal gate lines 205 may not be cut between the nanoribbons stacks 204-1, 204-2. In FIG. 2A, portions of the metal gate lines 205 are shown with dashed contours, indicating that these are the portions where the metal gate lines 205 may have been removed. The gate contacts 206 are in conductive contact with the gate stacks 106 (which are underneath the gate contacts 206 and, therefore, not seen in the view of FIGS. 2A-2C) provided over channel portions of the nanoribbon stacks 204-1, 204-2, providing electrical connectivity to the gates of the nanoribbon transistors. Thus, portions of the gate contacts 206 intersecting the gate stacks 106 are in conductive contact with the gate stacks 106 and serve as gate contacts for the transistors. Although the view illustrated in FIGS. 2A-2C illustrates only one gate contact 206 coupled with a given gate stack, in some examples, as described herein, both frontside and backside gate contacts may be provided for one or more transistors.

In some examples, S/D contact lines 213 may be cut and removed where isolation regions and/or deep trench vias are placed. In FIG. 2A, portions of the S/D contact lines 213 are shown with dashed contours, indicating that these are portions where the S/D contact lines 213 may have been removed. In other examples, the S/D contact lines 213 may not be cut between the nanoribbon stacks 204-1, 204-2. The S/D contacts 214 are provided over S/D regions (e.g., the S/D regions 114-1 and 114-2 (which are underneath the S/D contacts 214 and, therefore, not seen in the view of FIGS. 2A-2C) of the nanoribbon stacks 204-1, 204-2, providing electrical connectivity to the S/D regions of the nanoribbon transistors. Thus, portions of the S/D contacts 214 intersecting the S/D regions are in conductive contact with the S/D regions and serve as S/D contacts for the transistors. While a particular arrangement of gate stacks 106, metal gate lines 205, gate contacts 206, S/D contact lines 213, and S/D contacts 214 is shown in FIG. 1 and FIG. 2A, in other embodiments, these elements may be arranged differently within the IC structure 200.

FIG. 2B illustrates a top-down view of a portion of the IC structure 200, including frontside and backside conductive vias coupled with the gate stack of a transistor. The front side of an IC structure or wafer refers to a side of the IC structure or wafer on or over which devices are formed, and a back side of the IC structure or wafer refers to the side of the IC structure or wafer that is opposite the front side. In the example illustrated in FIG. 2B, the IC structure 200 includes a first conductive via 260 coupled with a first gate contact from a first side of the IC structure 200 (e.g., the gate contact 206 over the nanoribbon stack 204-1 shown in FIG. 2B), and a second conductive via 262 coupled with a second gate contact from a second side of the IC structure 200 (second gate contact not shown in the view of FIG. 2B). In one example, the conductive via 260 is a frontside conductive via located in an interconnect layer over the device region (e.g., in a frontside metal layer). In one such example, the conductive via 262 is a backside conductive via located in an interconnect layer below the device region (e.g., in a backside metal layer). The example shown in FIG. 2B illustrates a backside conductive via 262 located in a region between the nanoribbon stack 204-1 and the nanoribbon stack 204-2 (e.g., not directly below the nanoribbon stack 204-1). In other examples, a backside conductive via coupled with a backside gate contact may be below and substantially aligned with the nanoribbon stack 204-1 and below and substantially aligned with the backside gate contact. For example, FIG. 2C illustrates a top-down view of a portion of the IC structure 200 that is identical to the example shown in FIG. 2B except for the location of the backside via 262. In FIG. 2C, the backside via 262 is below and substantially aligned with the nanoribbon stack 204-1. Therefore, in the example illustrated in FIG. 2C, both the frontside via 260 and the backside via 262 are substantially aligned with the gate stack with which they are coupled.

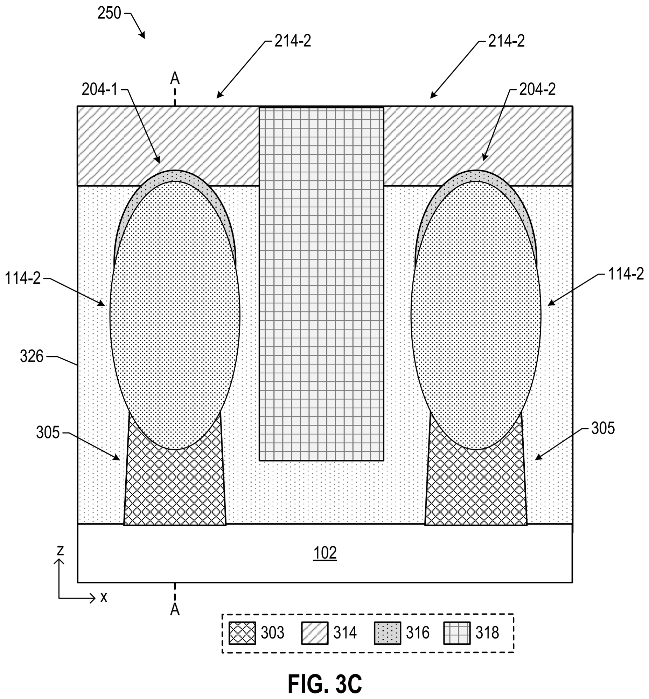

Referring again to FIG. 2A, in order to further illustrate details of the IC structure 200, FIG. 2A shows a portion 230 (illustrated with a dotted contour), a portion 240 (illustrated with a dot-dashed contour), and a portion 250 (illustrated with a double-dot-dashed contour). The portion 230 indicates an approximate outline of an example transistor such as the transistor 110, provided over the nanoribbon stack 204-1. The portion 240 illustrates a portion of the IC structure 200 with a gate contact 206 provided over a gate stack 106 over a channel portion of the nanoribbon stack 204-1 and a contact 206 provided over a gate stack 106 over a channel portion of the nanoribbon stack 204-2. FIGS. 3A-3C are cross-sectional side views along different cross-sections of the IC structure 200 of FIG. 2A, according to some embodiments of the present disclosure. In particular, FIG. 3A illustrates a cross-sectional side view of the portion 230 along a plane AA shown in FIG. 2A, FIG. 3B illustrates a cross-sectional side view of the portion 240 along a plane BB shown in FIG. 2A, and FIG. 3C illustrates a cross-sectional side view of the portion 250 along a plane CC shown in FIG. 2A. A number of elements referred to in the description of FIGS. 3A-3C with reference numerals are illustrated in these drawings with different patterns, with a legend showing the correspondence between the reference numerals and patterns being provided at the bottom of each drawing page containing FIGS. 3A-3C. For example, the legend illustrates that FIGS. 3A-3C use different patterns to show a gate electrode material 108, a semiconductor material 303, an electrically conductive material 306 of a gate contact 206, and so on.

As shown in FIG. 3A, the portion 230 includes a transistor similar to the transistor 110 but built on the basis of a nanoribbon stack 204-1 of a plurality of nanoribbons 104 instead of just one nanoribbon 104 as shown in FIG. 1. While four nanoribbons 104 are shown to be included in the nanoribbon stack 204-1, in other embodiments, fewer nanoribbons 104 or more nanoribbons 104 may be included. FIG. 3A illustrates a semiconductor material 303 as the material of the nanoribbons 104, further illustrating a subfin 305 of the semiconductor material 303 below the nanoribbon stack 204-1, although in some embodiments the nanoribbons 104 and at least a portion of the subfin 305 may include semiconductor materials of different material compositions. FIG. 3A illustrates the nanoribbon stack as being provided over the support 102 (e.g., over a substrate), however, in other examples, a substrate over which the nanoribbon stack 204-1 is provided may be thinned or removed. As shown in FIG. 3A, a gate stack having a gate insulator material 112 and a gate electrode material 108 may wrap around channel portions of the nanoribbons 104. FIG. 3A further illustrates a first S/D region 114-1 and a second S/D region 114-2 extending through the nanoribbon stack 204-1, electrically insulated/separated from the gate electrode material 108 and from the semiconductor material 303 of the subfin 305 by an insulator material 307. In some embodiments, the insulator material 307 may form so-called "dimples" 308 in areas where the insulator material 307 separates the S/D regions 114-1, 114-2 from the gate electrode material 108. The insulator material 307 may include any of the insulator materials described herein, e.g., any of the ILD materials described above.

Above the nanoribbon stack 204-1, FIG. 3A illustrates a gate contact 206 and S/D contacts 214 on either side of the gate contact 206, individually labeled as a first S/D contact 214-1 for making electrical contact to the first S/D region 114-1 and a second S/D contact 214-2 for making electrical contact to the second S/D region 114-2. The gate contact 206 may include an electrically conductive material 306 in electrically conductive contact with the gate electrode material 108. The gate contact 206 is an example of a frontside gate contact. In various embodiments, material compositions of the electrically conductive material 306 and the gate electrode material 108 may be substantially the same or different.

The S/D contacts 214-1, 214-2 may be electrically isolated from the gate electrode material 108 and the electrically conductive material 306 of the gate contact 206 by gate spacers 308. The gate spacers 308 may include one or more of spacer materials, diffusion barrier materials, adhesion materials, etc., as known in the art for forming contacts to various components of IC structures. In some embodiments, the gate spacers 308 may include low-k dielectrics and/or any of the ILD materials described above. Optionally, sidewalls of the S/D contacts 214 may be lined with one or more liners 310, where the liners 310 may include, but not limited to, materials comprising silicon and nitrogen (e.g., silicon nitride), materials comprising silicon and oxygen (e.g., silicon oxide), materials comprising silicon and carbon (e.g., silicon carbide), and/or their composites. Within the sidewalls, the S/D contacts 214-1, 214-2 may be filled with an electrically conductive fill material 314. In various embodiments, material compositions of the electrically conductive fill material 314 and the electrically conductive material 306 may be substantially the same (e.g., both may include/be tungsten) or different. At the bottom of the S/D contacts 214-1, 214-2, an interface material 316 is deposited to provide an interface between the S/D regions 114-1, 114-2 and the electrically conductive fill material 314 of S/D contacts 214-1, 214-2. The interface material 316 may include/be a metal such as titanium which, once deposited, may intermix with the material of the S/D regions 114-1, 114-2, e.g., with silicon, forming a compound (e.g., titanium silicide) that may help reduce contact resistance of the S/D contacts 214-1, 214-2. Although FIG. 3A illustrates an example in which the interface material 316 is only present on the bottom of the S/D contacts 214-1, 214-2 and not the sidewalls of the S/D contacts 214-1, 214-2, in other examples the interface material 316 may be present on the bottom and sidewalls of the S/D contacts 214-1, 214-2. In other embodiments, the interface material 316 is optional and may be absent from the bottom and/or absent from the side walls of the S/D contacts 214-1, 214-2. The S/D contacts 214-1 and 214-2 are examples of frontside S/D contacts. The example illustrated in FIG. 3A also includes a backside S/D contact 224 below the S/D region, below the nanoribbon stack 204-1, and coupled with the S/D region 114-1. In other examples, the IC structure may also include a backside S/D contact coupled with the SD region 114-2, or the IC structure may include only frontside S/D contacts.

FIG. 3B shows a cross-sectional side view of the IC structure 200 along the plane BB shown in FIG. 2A and in FIG. 3A (i.e., a gate cut). FIG. 3C shows the plane AA along which the cut of FIG. 3A is shown. Turning to FIG. 3B, the portion 240 illustrates the nanoribbon stacks 204-1, 204-2, a gate electrode material 108 around the nanoribbons 104 of the stacks 204-1, 204-2, an insulator material 318 between the nanoribbon stacks 204-1, 204-2, and an insulator material 322 surrounding sidewalls of the subfin 305. The insulator material 318 and the insulator material 322 may, e.g., include any of the ILD materials described above and may have either substantially the same or different material compositions. The insulator material 322 may sometimes be referred to as a "shallow-trench insulator" (STI).

The portion 240 also illustrates a gate contact 206 coupled with the gate electrode material 108 around the nanoribbons of the stack 204-1 and a gate contact 206 coupled with the gate electrode material 108 around the nanoribbons of the stack 204-2. The gate contacts 206 are over and coupled with (e.g., in contact with, e.g., in direct contact with) the gate electrode material 108 at a first side 360 (e.g., front side) of the IC structure 200. In the example illustrated in FIG. 3B, another gate contact 350 is below and coupled with the gate electrode material 108 around the nanoribbons of the stack 204-1 from a second side 362 (e.g., back side) of the IC structure 200. Thus, in the example illustrated in FIG. 3B, the gate electrode material 108 around the nanoribbons of the stack 204-1 is coupled with both frontside and backside gate contacts. In other examples, backside gate contacts 350 may be provided below both the nanoribbon stack 204-1 and below the nanoribbon stack 204-2.

FIG. 3C provides another helpful illustration of the IC structure 200 along the plane CC shown in FIG. 2A and in FIG. 3A (i.e., a cut across S/D regions of two different nanoribbon stacks 204-1 and 204-2). FIG. 3C shows the plane AA along which the cut of FIG. 3A is shown.

FIG. 3C illustrates two S/D regions 114-2 and the insulator material 318, which may be between the S/D regions 114-2. The two S/D regions 114-2 are provided over different ones of the nanoribbon stacks 204-1 and 204-2, as shown in FIG. 2A and FIG. 3C. FIG. 3C further illustrates an insulator material 326 that may surround the S/D regions 114-2, below the electrically conductive fill material 314 of the S/D contacts 214-2, and may also surround the sidewalls of the subfins 305 of the nanoribbon stacks 204-1 and 204-2. The insulator material 326 may, e.g., include any of the ILD materials described above and may have either substantially the same or different material compositions with any other insulator materials in the IC structure 200, e.g., with the insulator material 322 shown in FIG. 3B.

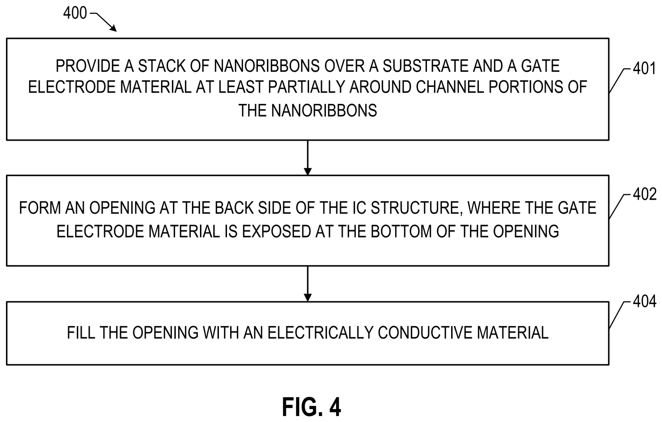

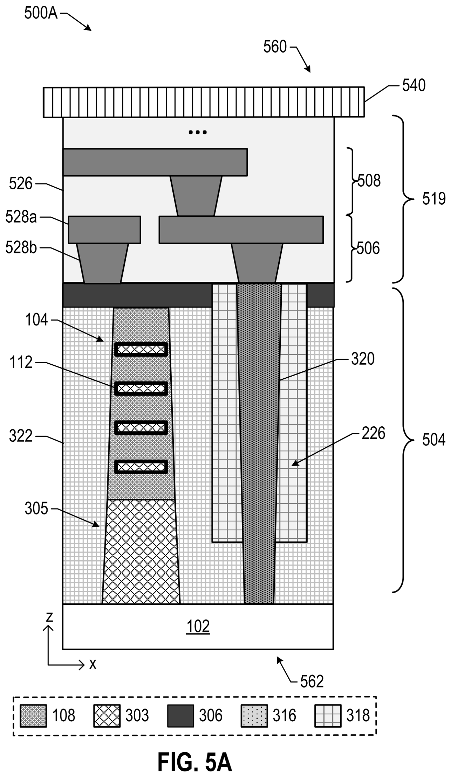

FIG. 4 is a flow diagram of an example method for fabricating an IC structure including a nanoribbon-based transistor with a backside gate contact, in accordance with some embodiments. FIGS. 5A-5D provide cross-sectional side views at various stages in the fabrication of an example IC structure according to the method of FIG. 4, in accordance with some embodiments.

Although the operations of the method of FIG. 4 are illustrated once each and in a particular order, the operations may be performed in any suitable order and repeated as desired. For example, one or more operations may be performed in parallel to fabricate multiple IC structures including a nanoribbon-based transistor with a backside gate contact substantially simultaneously. In another example, the operations may be performed in a different order to reflect the structure of an IC device in which an IC structure including a nanoribbon-based transistor with a backside gate contact will be implemented.

In addition, the example fabricating method of FIG. 4 may include other operations not specifically shown in FIG. 4, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 4, the method 400 begins with a process 401 of providing a stack of nanoribbons over a substrate and a gate electrode material at least partially around channel portions of the nanoribbons. An IC structure 500A of FIG. 5A illustrates an example result of the process 401. The IC structure 500A includes device region 504 including a support 102 and a stack 204-1 of nanoribbons 104 over the support 102. The device region 504 may include all portions of the IC structure 200 as shown in FIG. 3B. For example, channel portions of the nanoribbons of the stack 204-1 are at least partially surrounded by a gate electrode material 108. In the example illustrated in FIG. 5A, the IC structure 500A includes the insulator material 322 in the region with the subfins 305 (e.g., on sidewalls of the subfins 305). In the example illustrated in FIG. 5A, a gate contact structure including an electrically conductive material 306 is over and around the gate electrode material 108. In some examples, one or more further materials, such as the insulator material 318, may be present between the stack 204-1 and another stack, such as shown in FIG. 3B. The example illustrated in FIG. 5A also includes a deep trench via 226 through the device region 504. In some embodiments, vias (e.g., deep trench vias) may be used for backside power, signal, or ground delivery. The deep trench via 226 includes an electrically conductive via fill material 320 filling the deep trench via 226, which may include any suitable conductive material, e.g., tungsten, and may have substantially the same or different material composition with the electrically conductive material 306 of the gate contact 206 and/or with the electrically conductive fill material 314 of the S/D contacts 214.

The IC structure 500A further includes a first interconnect layer 506 formed above the device region 504 over a first side 560 of the IC structure, and a second interconnect layer 508 formed above the first interconnect layer 506. Additional interconnect layers may be present above the second interconnect layer 508. A collection of interconnect layers such as the interconnect layers 506, 508, etc., may be referred to as a "metallization stack" 519 of the IC structure 500A. Interchangeably, the metallization stack 519 may be referred to as the "back end of line (BEOL) layer(s)" of the IC structure 500A, while the device region 504 may be referred to as the "front end of line (FEOL) layer(s)" of the IC structure 500A.

Electrical signals, such as power and/or input/output (I/O) signals, may be routed to and/or from the devices (e.g., the transistors) of the device region 504 through one or more interconnect layers disposed on the device region 504 (illustrated in FIG. 5A as interconnect layers 506 and 508). For example, electrically conductive features of the device region 504 (e.g., the electrically conductive material 306 of the gate contact 206 and the electrically conductive via fill material 320 of the deep trench via 226) may be electrically coupled with the interconnect structures of the interconnect layers 506 and 508. The interconnect structures (e.g., conductive lines 528a and conductive vias 528b) may be arranged within the interconnect layers of the metallization stack 519 to route electrical signals according to a wide variety of designs (in particular, the arrangement is not limited to the particular configuration of interconnect structures depicted in FIG. 5A). Although a particular number of interconnect layers 506 and 508 is depicted in FIG. 5A, embodiments of the present disclosure include IC structures having more or fewer interconnect layers than depicted.

The interconnect structures may include conductive lines 528a and/or conductive vias 528b filled with an electrically conductive material such as a metal. The lines 528a may be arranged to route electrical signals in a direction of a plane that is substantially parallel with a surface of the support 102 upon which the device region 504 is formed. For example, the lines 528a may route electrical signals in a direction in and out of the page from the perspective of FIG. 5A. The vias 528b may be arranged to route electrical signals in a direction of a plane that is substantially perpendicular to the surface of the support 102 upon which the device region 504 is formed. In some embodiments, the vias 528b may electrically couple lines 528a of different interconnect layers of the metallization stack 519 together.

The interconnect layers 506 and 508 may include a dielectric material 526 disposed between the interconnect structures, as shown in FIG. 5A. In some embodiments, the dielectric material 526 disposed between the interconnect structures in different ones of the interconnect layers 506 and 508 may have different compositions; in other embodiments, the composition of the dielectric material 526 between different interconnect layers 506 and 508 may be the same.

A first interconnect layer 506 may be formed above the device region 504. In some embodiments, the first interconnect layer 506 may include lines 528a and/or vias 528b, as shown. The lines 528a and/or the vias 528b of the first interconnect layer 506 may be coupled with contacts (e.g., gate contacts 206 and/or S/D contacts 214-1, 214-2 of the IC structure 200) of the device region 504.

A second interconnect layer 508 may be formed above the first interconnect layer 506. In some embodiments, the second interconnect layer 508 may include vias 528b to couple the lines 528a of the second interconnect layer 508 with the lines 528a of the first interconnect layer 506. Although the lines 528a and the vias 528b are structurally delineated with a line within each interconnect layer (e.g., within the second interconnect layer 508) for the sake of clarity, the lines 528a and the vias 528b may be structurally and/or materially contiguous (e.g., simultaneously filled during a dual-damascene process) in some embodiments.

Additional interconnect layers, as desired, may be formed in succession on the second interconnect layer 508 according to similar techniques and configurations described in connection with the second interconnect layer 508 or the first interconnect layer 506. In some embodiments, the interconnect layers that are "higher up" in the metallization stack 519 in the IC structure 500A (i.e., farther away from the device region 504) may be thicker. Although not specifically shown in FIG. 5A, in some embodiments, the IC structure 500A may further include a solder resist material (e.g., polyimide or similar material) and one or more conductive contacts formed on the interconnect layers of the metallization stack 519.

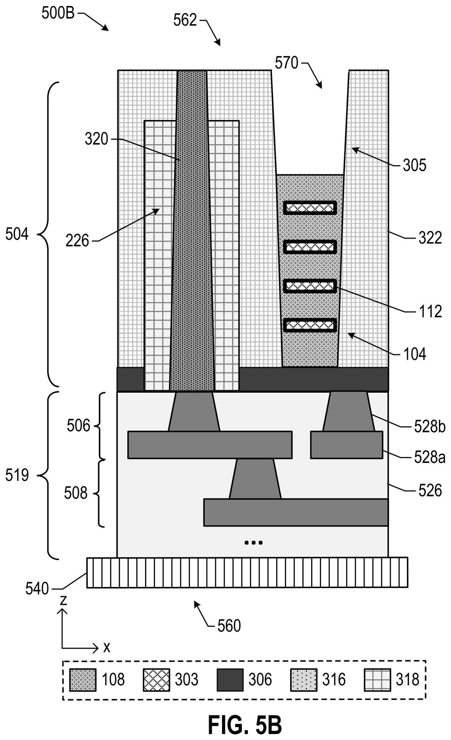

FIG. 5A illustrates that, once the metallization stack 519 has been formed, a carrier substrate 540 may be attached to the top of the metallization stack 519 of the IC structure 500A. The carrier substrate 540 may include any suitable structure that may provide adequate mechanical support for subsequent processes (such as shown in FIGS. 5B-5D).

The method 400 continues with a process 402 of forming an opening at the back side of the IC structure, where the gate electrode material is exposed at the bottom of the opening. An IC structure 500B of FIG. 5B illustrates an example result of the process 402. As can be seen in FIG. 5B, the IC structure 500A of FIG. 5A has been flipped over to expose the second side 562 of the IC structure 500B. An opening 570 has been formed over the nanoribbon stack 204-1 from the second side 562 of the IC structure. In the example illustrated in FIG. 5B, the support 102 has been removed, exposing the subfin 305 and the fill material 320 at the bottom of the deep trench via 226. In other examples, only a portion of the support 102 may be removed.

Forming the opening 570 may involve any suitable etching technique, e.g., a dry etch, such as e.g., radio frequency (RF) reactive ion etch (RIE) or inductively coupled plasma (ICP) RIE may be used for forming the opening 570. In some embodiments, the etch performed in the process 402 may include an anisotropic etch, using etchants in a form of e.g., chemically active ionized gas (i.e., plasma). In the example illustrated in FIG. 5B, the opening 570 is formed by removing the material in the subfin 305 (e.g., the semiconductor material 303 of the subfin 305) to expose the gate electrode material 108 at the bottom of the opening 570. In some examples, a portion of the gate electrode material 108 and/or portions of the insulator material 322 may also be removed.

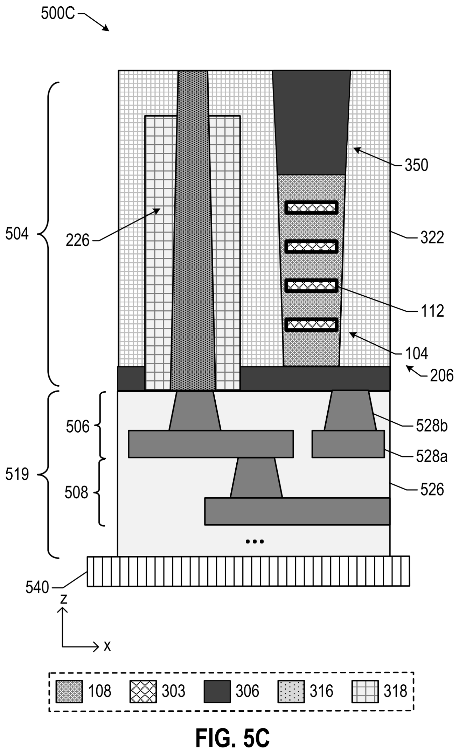

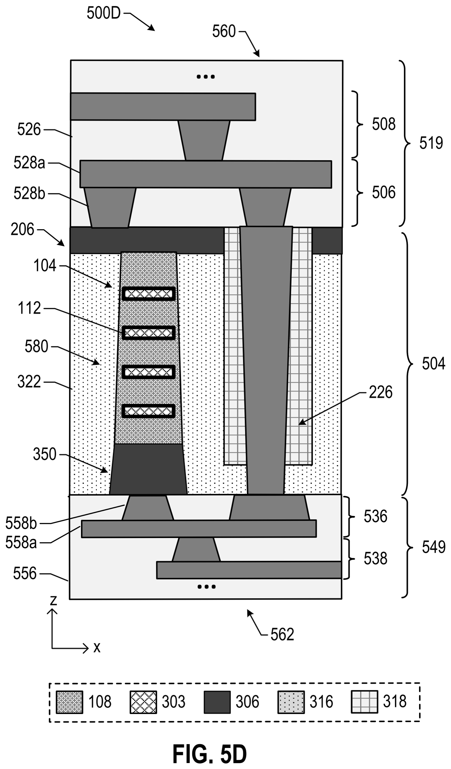

The method 400 continues with a process 404 of filling the opening with an electrically conductive material. An IC structure 500C of FIG. 5C illustrates an example result of the process 404. The IC structure 500C includes a second gate contact 350 including the conductive material 306. The electrically conductive material 306 may include any suitable electrically conductive material, such as any of those described above, and may be deposited in the process 404 using a technique such as atomic layer deposition (ALD), chemical vapor deposition (CVD), plasma enhanced CVD (PECVD), or/and physical vapor deposition (PVD) processes such as sputter. In one such example, the gate contact 206 is a frontside gate contact structure and the gate contact 350 is a backside gate contact structure. Although the gate contact 206 and the gate contact 350 are shown as including the same conductive material 306, in other examples, the gate contacts 206 and 350 may include different conductive materials. Also, the dimensions and shapes of the gate contacts 206 and 350 may be different than shown in FIG. 5C.For example, part of the gate contact 206 may be coplanar with the nanoribbons 104, or the gate contact 206 may be disposed above the nanoribbon stack 204-1 as shown in FIG. 5D. Additionally, although the gate contact 350 is shown as having a width that is slightly greater than the nanoribbons 104, the width of the gate contact 350 may be greater than, about the same as, or smaller than the width of the nanoribbons 104 (where the width of the gate contact 350 is a dimension of the gate contact in a plane substantially parallel with the nanoribbons, e.g., along the x-axis as shown in FIG. 5D).

FIG. 5D illustrates an IC structure 500D that is substantially the same as the IC structure 500C, but further includes a metallization stack 549 at the back side of the device region 504, and the IC structure 500D has been flipped over (relative to the IC structure 500C) and the carrier substrate 540 has been removed. As shown in FIG. 5D, the metallization stack 549 may include a first interconnect layer 536 formed on the back side of the device region 504, and a second interconnect layer 538 formed above the first interconnect layer 536 (note that in FIG. 5D, the IC structure has been flipped so that the side 560 is up, and therefore the interconnect layer 538 appears below the interconnect layer 536). Additional interconnect layers may be present above the second interconnect layer 538.

Electrical signals, such as power and/or input/output (I/O) signals, may be routed to and/or from the devices (e.g., the transistors) of the device region 504 through one or more interconnect layers disposed on the back side of the device region 504 (illustrated in FIG. 5D as interconnect layers 536 and 538). For example, electrically conductive features of the device region 504 (e.g., the backside gate contact 350 and the electrically conductive via fill material 320 of the deep trench via 226) may be electrically coupled with the interconnect structures of the interconnect layers 536 and 538. The interconnect structures of the metallization stack 549 may be arranged within the interconnect layers of the metallization stack 549 to route electrical signals according to a wide variety of designs (in particular, the arrangement is not limited to the particular configuration of interconnect structures depicted in FIG. 5D). Although a particular number of interconnect layers 536 and 538 is depicted in FIG. 5D, embodiments of the present disclosure include IC structures having more or fewer interconnect layers than depicted.

In some embodiments, the interconnect structures may include conductive lines 558a and/or conductive vias 558b filled with an electrically conductive material such as a metal. The interconnect layers 536 and 538 may include a dielectric material 556 disposed between the interconnect structures, as shown in FIG. 5D. Descriptions provided above with respect to the first interconnect layer 506, second interconnect layer 508, metallization stack 519, dielectric material 526, conductive lines 528a, and conductive vias 528b are applicable to, respectively, the first interconnect layer 536, second interconnect layer 538, metallization stack 549, dielectric material 556, conductive lines 558a, and conductive vias 558b. Therefore, in the interest of brevity, these descriptions are not repeated.

Since the metallization stack 519 is provided on the front side of the device region 504, while the metallization stack 549 is provided on the back side, there may be features indicative of this in the IC structure 500D. In particular, for certain manufacturing processes, cross-sectional shapes of interconnects in a plane such as that of FIG. 5D (e.g., in a plane substantially perpendicular to the device region 504) may be tapered and substantially trapezoidal, i.e., a cross-section of an interconnect may have two substantially parallel sides, one of which shorter than the other. Because the vias 528b are formed on a front side (e.g., the side 560) of the device region 504, their trapezoidal shapes may be arranged so that their shorter sides are closer to a back side (e.g., the side 562) of the device region 504 than their longer sides. Similarly, because the deep trench vias 226 were formed from the same side, the trapezoidal shapes of the deep trench vias 226 may be arranged so that their shorter sides are also closer to a back side of the device region 504 than their longer sides. Because the vias 558b are formed on the back side (e.g., the side 562) of the device region 504, their trapezoidal shapes may be arranged so that their shorter sides are closer to a back side of the device region 504 than their longer sides. Thus, in one example, a conductive via 528b coupled with the gate contact 206 tapers in a first direction, and a second conductive via coupled with the gate contact 350 tapers in a second direction that is opposite the first direction (e.g., a frontside via coupled with the frontside gate contact tapers towards the nanoribbon stack 204-1, and a backside via coupled with a backside gate contact also tapers towards the nanoribbon stack 204-1, so that the vias taper in opposite directions).

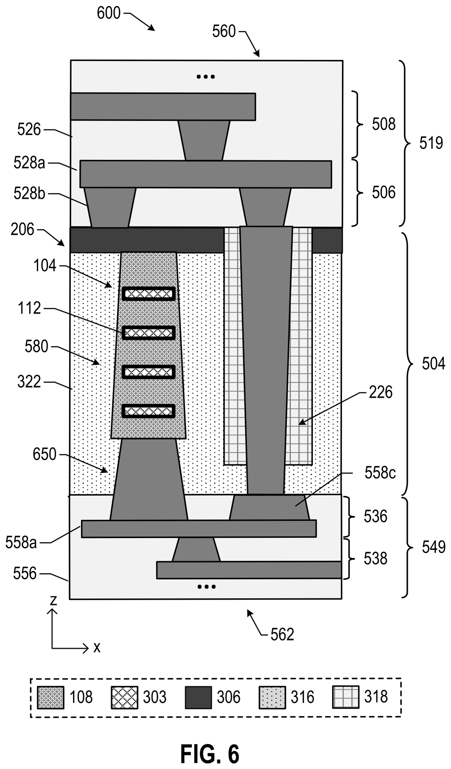

FIG. 6 provides a cross-sectional view of another example IC structure 600 including a nanoribbon-based transistor with a backside gate contact. The IC structure 600 is similar to the IC structure 500D of FIG. 5D; however, a difference between the IC structure 600 and the IC structure 500D is that the IC structure 600 includes a single conductive structure 650 coupled with the gate electrode material 108 that is both a backside gate contact and a conductive via. Therefore, the conductive structure 650 is between and coupled with the gate electrode material 108 and a line 558a of the backside metallization stack 549. Thus, the conductive structure 650 could be viewed as a conductive via that directly couples with the gate electrode material 108 without an intervening gate contact structure, or the conductive structure 650 could be viewed as a gate contact that extends into the interconnect layer 536 and coupled with the line 558a. The conductive structure 650 shown in FIG. 6 is coplanar with one or more conductive vias, such as the via 558c coupled with the deep via 226.

Certain features in the IC structure may identify an IC structure that includes a separate gate contact and via, or a combined gate contact and via. For example, in FIG. 5D where the IC structure 500D includes a gate contact 350 that is coupled with and separate from the via 558b, there may be an interface between the gate contact 350 and the via 558b, the gate contact 350 and the via 558b may have different widths at the interface between the gate contact 350 and the via 558b, and/or the gate contact 350 and the via 558b may include different conductive materials.

In contrast, FIG. 6 depicts a conductive structure 650 that includes a continuous conductive material between the gate electrode material 108 and the line 558a. Additionally, the sidewalls of the conductive structure 650 may lack the discontinuities/edges caused by different widths at the interface between the gate contact 350 and the via 558b. In other examples, even when the gate contact 350 and the via 558b are formed as separate structures, it may not be evident, e.g., due to the lack of an interface and/or the same conductive materials being used.

Thus, FIG. 4 illustrates an example method 400 of fabricating an IC structure including both frontside and backside gate contacts. Performing the method 400 may result in features in the final IC structures that are characteristic of the use of the method 400. For example, one such feature is illustrated in the IC structure 500D shown in FIG. 5D, which shows a device region 504 including a transistor 580 that includes a channel region comprising a portion of the nanoribbons 104 of a semiconductor material 303, a gate structure including a conductive material 108 at least partially around the channel region, a first gate contact 206 over the nanoribbons 104 and coupled with the gate structure (e.g., coupled with the gate electrode material 108), and a second gate contact 350 below the nanoribbons 104 and coupled with the gate structure. The IC structure 500D further includes a first interconnect layer 506 over the device region 504 (e.g., a frontside metal layer), where the first interconnect layer 506 includes a first conductive via 528b coupled with the first gate contact 206, and a second interconnect layer 536 below the device region 504 (e.g., backside metal layer), where the second interconnect layer 536 includes a second conductive via 558b coupled with the second gate contact 350. The IC structure 500D also includes a third conductive via 226 through the device region 504, where the third conductive via 226 is coupled with the first conductive via 528b and the second conductive via 558b. Another such feature is shown in FIGS. 3A and 3B, which show that the backside gate contact 350 may be coplanar with a backside S/D contact 224. For example, FIG. 3A shows an S/D region 114-1 of a transistor and an S/D contact 224 below the nanoribbons 104 and coupled with the S/D region 114-1. FIG. 3B shows the gate contact 350, where the S/D contact 224 is coplanar with the gate contact 350. FIG. 5D illustrates an example in which the gate contact 350 is coplanar with a portion (e.g., bottom) of the deep via 226. FIG. 6 illustrates an example in which the gate contact and via are a combined structure that provides a backside gate contact and via, which may also be fabricated according to the method 400 of FIG. 4.

FIG. 3B also shows an example in which the gate contact 350 is coplanar with the subfin 305 of an adjacent nanoribbon stack 204-2. In some examples, a portion of a backside gate contact may be coplanar with a portion of the gate of another transistor in the same layer/device region (e.g., an adjacent transistor). For example, FIG. 3B shows an example with a second transistor (e.g., having a second channel region in a second portion of the nanoribbon stack 204-2) and a second gate structure including the gate electrode material 108 at least partially around the second channel region, where a portion of the gate electrode material 108 around the stack 204-2 is coplanar with a portion of the gate contact 350. According to examples described herein, an IC structure including a nanoribbon-based transistor with both a frontside and a backside gate contact may reduce the gate resistance, which may improve the device performance and enable the device to operate at higher frequencies.

IC devices/structures including a nanoribbon-based transistor with a backside gate contact as described herein (e.g., as described with reference to FIGS. 3A-3C, 4, and 5A-5D) may be used to implement any suitable components. For example, in various embodiments, IC structures described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices and structures disclosed herein, e.g., the IC devices/structures 100, 200, or 500D, or any variations thereof, may be included in any suitable electronic component.

FIGS. 7-10 illustrate various examples of apparatuses that may include any of the IC devices or structures disclosed herein.

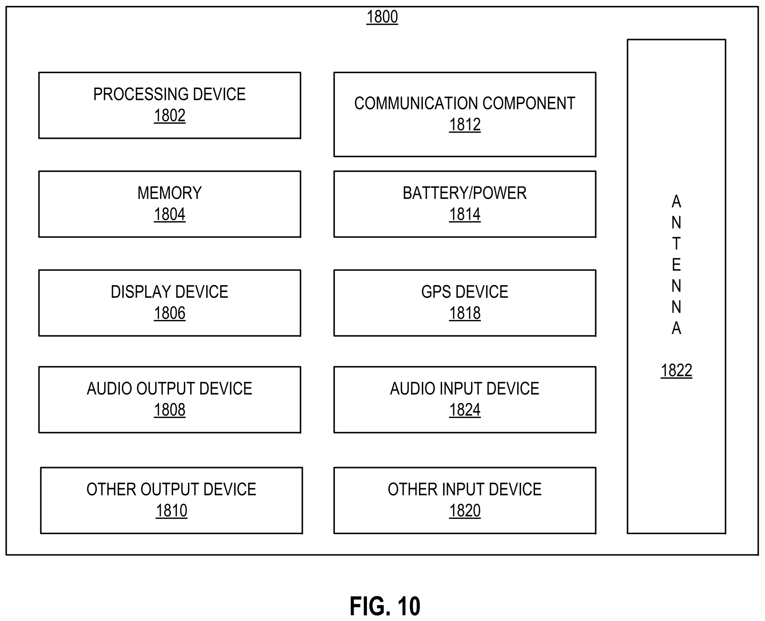

FIG. 7 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures as described herein (e.g., any of the IC devices/structures 100, 200, or 500D, described herein), one or more transistors (e.g., nanoribbon transistors of the IC devices/structures 100, 200, or 500D) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array.

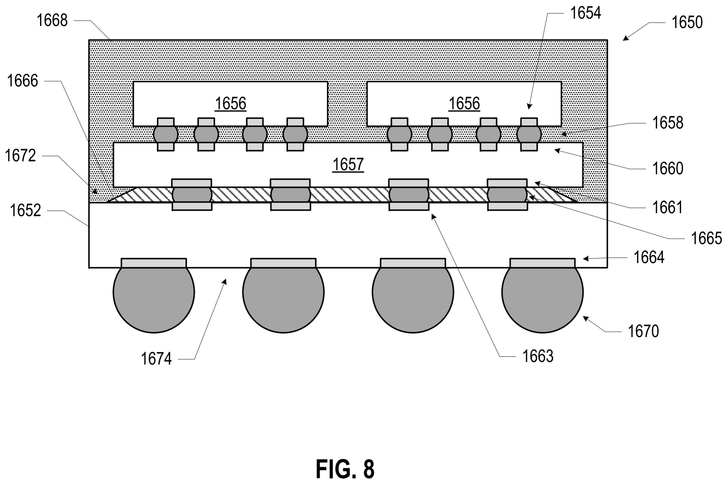

FIG. 8 is a side, cross-sectional view of an example IC package 1650 that may include one or more IC structures in accordance with any of the embodiments disclosed herein (e.g., any of the IC devices/structures 100, 200, or 500D, described herein). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 8 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 8 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

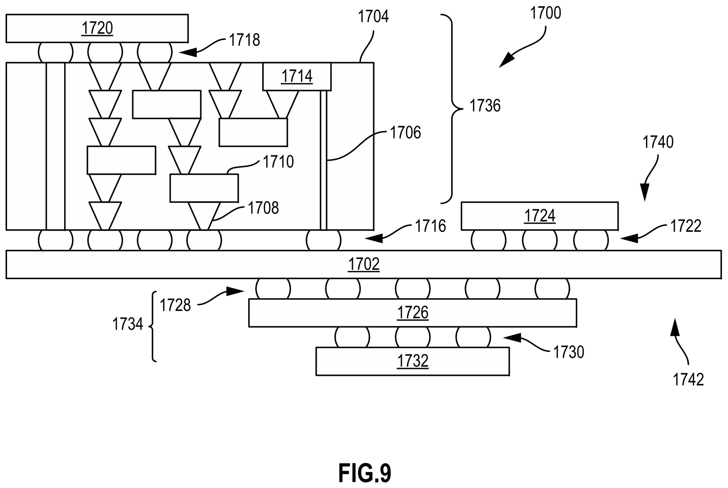

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 8 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 9.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 8 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 8, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 9 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 7 (e.g., may include one or more the IC devices/structures 100, 200, or 500D).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 7), an IC device (e.g., any of the IC devices/structures 100, 200, or 500D, described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 9, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example electrical device 1800 that may include one or more IC devices/structures 100, 200, or 500D in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 10 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 10, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a nanoribbon of a semiconductor material; a gate electrode material at least partially around the nanoribbon; a first gate contact structure (e.g., frontside gate contact) over the nanoribbon and coupled with the gate electrode material; a second gate contact structure (e.g., backside gate contact) below the nanoribbon and coupled with the gate electrode material; a first conductive interconnect (e.g., frontside via) over and coupled with the first gate contact structure; and a second conductive interconnect (e.g., backside via) below and coupled with the second gate contact structure.

Example 2 provides the IC structure of example 1, further including a conductive via (e.g., deep via/DVB) coplanar with the nanoribbon and coupled with the first gate contact structure and with the second gate contact structure.

Example 3 provides the IC structure of any one of examples 1-2, where: the first conductive interconnect includes a first conductive via that tapers in a first direction, and the second conductive interconnect includes a second conductive via that tapers in a second direction that is opposite the first direction (e.g., the frontside via tapers towards the nanoribbons, and the backside via also tapers towards the nanoribbons, so that the vias taper in opposite directions).

Example 4 provides the IC structure of any one of examples 1-3, further including a region of a doped semiconductor material in the nanoribbon, where the region is a source region or a drain region of a transistor, and where a portion of the nanoribbon is a channel region of the transistor; and a contact structure (e.g., backside S/D contact structure) coupled with the region, where the contact structure is either a source contact structure or a drain contact structure, and where the contact structure is coplanar with the second gate contact structure (e.g., the backside gate contact structure is coplanar with the backside S/D contact structure).

Example 5 provides the IC structure of example 4, where the contact structure is a first contact structure, and where the IC structure further includes a second contact structure (e.g., frontside S/D contact structure) coupled with the region, where the second contact structure is over the nanoribbon.

Example 6 provides the IC structure of any one of examples 1-5, further including a stack of nanoribbons including the nanoribbon, where the second gate contact structure is below a bottom nanoribbon of the stack.

Example 7 provides the IC structure of any one of examples 1-6, where the nanoribbon is a first nanoribbon, the gate electrode material is a first gate electrode material, and where the IC structure further includes a second nanoribbon adjacent to and coplanar with the first nanoribbon (e.g., a nanoribbon of a second stack); and a second gate electrode material at least partially around the second nanoribbon, where the second gate contact structure is coplanar with the second gate electrode material.

Example 8 provides an IC structure, including a device region including a transistor, where the transistor includes a channel region including a portion of a nanoribbon of a semiconductor material, a gate structure including a conductive material at least partially around the channel region, a first gate contact over the nanoribbon and coupled with the gate structure, and a second gate contact below the nanoribbon and coupled with the gate structure; a first interconnect layer over the device region (e.g., a frontside metal layer), where the first interconnect layer includes a first conductive via coupled with the first gate contact; and a second interconnect layer below the device region (e.g., backside metal layer), where the second interconnect layer includes a second conductive via coupled with the second gate contact.

Example 9 provides the IC structure of example 8, further including a third conductive via through the device region, where the third conductive via is coupled with the first conductive via and the second conductive via.

Example 10 provides the IC structure of any one of examples 8-9, further including a source region of the transistor, where the source region includes a doped semiconductor material; and a source contact below the nanoribbon and coupled with the source region, where the source contact is coplanar with the second gate contact.

Example 11 provides the IC structure of any one of examples 8-10, where the transistor is a first transistor, the portion is a first portion, the nanoribbon is a first nanoribbon, the channel region is a first channel region, the gate structure is a first gate structure, and where the IC structure further includes a second transistor in the device region, where the second transistor includes a second channel region including a second portion of a second nanoribbon, and a second gate structure including the conductive material at least partially around the second channel region, where a bottom portion of the second gate structure is coplanar with the second gate contact of the first transistor.

Example 12 provides the IC structure of example 11, where: the device region includes a subfin structure below and substantially aligned with the second nanoribbon, and the second gate structure is coplanar with the subfin structure.

Example 13 provides the IC structure of example 11, further including a third gate contact above and coupled with the second gate structure, and a fourth gate contact below and coupled with the second gate structure (e.g., an adjacent nanoribbon-based transistor may also have both frontside and backside gate contacts).

Example 14 provides an IC structure according to any one of examples 1-13, where: the IC structure includes or is a part of a central processing unit.

Example 15 provides an IC structure according to any one of examples 1-14, where: the IC structure includes or is a part of a memory device.

Example 16 provides an IC structure according to any one of examples 1-15, where: the IC structure includes or is a part of a logic circuit.

Example 17 provides an IC structure according to any one of examples 1-16, where: the IC structure includes or is a part of input/output circuitry.

Example 18 provides an IC structure according to any one of examples 1-17, where: the IC structure includes or is a part of a field programmable gate array transceiver.

Example 19 provides an IC structure according to any one of examples 1-18, where: the IC structure includes or is a part of a field programmable gate array logic.

Example 20 provides an IC structure according to any one of examples 1-19, where: the IC structure includes or is a part of a power delivery circuitry.

Example 21 provides an IC package including an IC die including an IC structure according to any one of examples 1-20; and a further IC component, coupled to the IC die.

Example 22 provides an IC package according to example 21, where: the further IC component includes a package substrate.

Example 23 provides an IC package according to example 21, where: the further IC component includes an interposer.

Example 24 provides an IC package according to example 21, where: the further IC component includes a further IC die.

Example 25 provides a computing device including a carrier substrate and an IC structure coupled to the carrier substrate, where the IC structure is an IC structure according to any one of examples 1-20, or the IC structure is included in the IC package according to any one of claims 21-24.

Example 26 provides a computing device according to example 25, where: the computing device is a wearable or handheld computing device.

Example 27 provides a computing device according to examples 25 or 26, where: the computing device further includes one or more communication chips.

Example 28 provides a computing device according to any one of examples 25-27, where: the computing device further includes an antenna.

Example 29 provides a computing device according to any one of examples 25-28, where: the carrier substrate is a motherboard.

Example 30 provides a method of fabricating an IC structure, including providing a stack of nanoribbons over a first side (e.g., front side) of the IC structure; providing a gate electrode material at least partially around a portion of the nanoribbons; forming a first gate contact structure in contact with the gate electrode material at the first side; and forming a second gate contact structure in contact with the gate electrode material at a second side of the IC structure opposite the first side, where forming the second gate contact structure includes forming an opening in the second side of the IC structure, where the opening is substantially aligned with the stack, and where the gate electrode material is exposed in the opening; and filling the opening with a conductive material.

Example 31 provides the method of example 30, further including prior to forming the second gate contact structure, providing one or more interconnect layers over the stack from the first side.

Example 32 provides the method of example 31, where: providing the one or more interconnect layers includes forming a conductive via over and coupled with the first gate contact structure.

Example 33 provides the method of any one of examples 30-32, where the one or more interconnect layers are one or more first interconnect layers, and where the method further includes after forming the second gate contact structure, providing one or more second interconnect layers over the stack from the second side.

Example 34 provides the method of any one of examples 30-33, where: forming the second gate contact structure includes flipping over the IC structure and thinning a substrate from the second side prior to forming the opening.

Example 35 provides the method of any one of examples 30-34, further including forming a source or drain contact structure from the second side.

Example 36 provides the method of any one of examples 30-35, where: forming the opening includes removing a subfin below and substantially aligned with the stack.

Example 37 provides the method of claim 30, wherein forming the gate contact structure includes forming a combined gate contact structure/via.

Example 38 provides a method according to any one of examples 30-37, where the IC structure is an IC structure according to any one of the preceding examples.

Example 39 provides that the method of any one of examples 30-38 is a process of making an IC structure in accordance with any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit, IC, structure, comprising:
a nanoribbon of a semiconductor material;
a gate electrode material at least partially around the nanoribbon;
a first gate contact structure over the nanoribbon and coupled with the gate electrode material;
a second gate contact structure below the nanoribbon and coupled with the gate electrode material;
a first conductive interconnect over and coupled with the first gate contact structure; and
a second conductive interconnect below and coupled with the second gate contact structure.

2. The IC structure of claim 1, further comprising:
a conductive via coplanar with the nanoribbon and coupled with the first gate contact structure and with the second gate contact structure.

3. The IC structure of any one of claims 1-2, wherein:
the first conductive interconnect comprises a first conductive via that tapers in a first direction, and
the second conductive interconnect comprises a second conductive via that tapers in a second direction that is opposite the first direction.

4. The IC structure of any one of claims 1-3, further comprising:
a region of a doped semiconductor material in the nanoribbon, wherein the region is a source region or a drain region of a transistor, and wherein a portion of the nanoribbon is a channel region of the transistor; and
a contact structure coupled with the region, wherein the contact structure is either a source contact structure or a drain contact structure, and wherein the contact structure is coplanar with the second gate contact structure.

5. The IC structure of claim 4, wherein the contact structure is a first contact structure, and wherein the IC structure further comprises:
a second contact structure coupled with the region, wherein the second contact structure is over the nanoribbon.

6. The IC structure of any one of claims 1-5, further comprising:
a stack of nanoribbons comprising the nanoribbon, wherein the second gate contact structure is below a bottom nanoribbon of the stack.

7. The IC structure of any one of claims 1-6, wherein the nanoribbon is a first nanoribbon, the gate electrode material is a first gate electrode material, and wherein the IC structure further comprises:
a second nanoribbon adjacent to and coplanar with the first nanoribbon; and
a second gate electrode material at least partially around the second nanoribbon, wherein the second gate contact structure is coplanar with the second gate electrode material.

8. A method of fabricating an integrated circuit, IC, structure, comprising:
providing a stack of nanoribbons over a first side of the IC structure;
providing a gate electrode material at least partially around a portion of the nanoribbons;
forming a first gate contact structure in contact with the gate electrode material at the first side; and
forming a second gate contact structure in contact with the gate electrode material at a second side of the IC structure opposite the first side, wherein forming the second gate contact structure comprises:
forming an opening in the second side of the IC structure, wherein the opening is substantially aligned with the stack, and wherein the gate electrode material is exposed in the opening; and
filling the opening with a conductive material.

9. The method of claim 8, further comprising:
prior to forming the second gate contact structure, providing one or more interconnect layers over the stack from the first side.

10. The method of claim 9, wherein:
providing the one or more interconnect layers comprises: forming a conductive via over and coupled with the first gate contact structure.

11. The method of claim 10, wherein the one or more interconnect layers are one or more first interconnect layers, and wherein the method further comprises:
after forming the second gate contact structure, providing one or more second interconnect layers over the stack from the second side.

12. The method of any one of claims 8-11, wherein:
forming the second gate contact structure comprises: flipping over the IC structure and thinning a substrate from the second side prior to forming the opening.

13. The method of any one of claim 8-12, further comprising:
forming a source or drain contact structure from the second side.

14. The method of any one of claims 8-13, wherein:
forming the opening comprises removing a subfin below and substantially aligned with the stack.

15. The method of any one of claims 8-14, wherein the IC structure is in accordance with any one of claims 1-7.
